# FASCICULE DE BREVET EUROPEEN

(11) **EP 2 330 737 B1**
(45) Date de publication et mention de la délivrance du brevet: **20.06.2012**
(21) Numéro de dépôt: 10193600.3
(22) Date de dépôt: 03.12.2010
(51) Int. Cl.: H03H 3/02

(54) **Procédé de réalisation d'un resonateur acoustique a ondes de volumes de type fbar**
Herstellungsverfahren eines akustischen Resonators mit Volumenwellen vom Typ FBAR
Method for manufacturing an acoustic resonator with FBAR body waves

(30) Priorité: 04.12.2009 FR 0905874
(43) Date de publication de la demande: 08.06.2011
(73) Titulaire: Commissariat à l'Énergie Atomique et aux Énergies Alternatives, 75015 Paris (FR)
(72) Inventeur: Pijolat, Mathieu, 38000, GRENOBLE (FR)
(74) Mandataire: Esselin, Sophie

(56) Documents cités:
- US-A1- 2003 199 105
- BRUEL M: "Silicon on insulator material technology", ELECTRONICS LETTERS, IEE STEVENAGE, GB LNKD- DOI:10.1049/EL:19950805, vol. 31, no. 14, 6 juillet 1995 (1995-07-06), pages 1201-1202, XP006003062, ISSN: 0013-5194

## Description

Le domaine de l'invention est celui des dispositifs électromécaniques exploitant la génération d'ondes acoustiques dans des couches minces piézoélectriques en vue de réaliser des fonctions de filtre électrique.

De tels dispositifs présentent des fréquences de fonctionnement de l'ordre de quelques centaines de MHz à quelques GHz, et sont utilisés dans des circuits de transmission radiofréquence (téléphone portable, liaison radio, échange de données sans fil,...), de traitement du signal ou dans des systèmes de capteurs.

Plus précisément le domaine de l'invention est celui des dispositifs à ondes de volume, encore dénommé « BAW » pour « Bulk Acoustic Wave ».

Un résonateur BAW peut servir notamment à réaliser des filtres passe bande au-delà du gigahertz pour des applications de téléphonie mobile par exemple. De façon usuelle, le matériau piézoélectrique est déposé par des techniques comme la pulvérisation cathodique. Une alternative au dépôt est le report de couches monocristallines, qui peut être employé pour améliorer les propriétés de tels résonateurs.

L'avantage est multiple : ces matériaux comportent intrinsèquement moins de pertes (comparé au nitrure d'aluminium AIN ou l'oxyde de zinc ZnO obtenus par dépôts), peuvent avoir des couplages bien supérieurs et, selon l'orientation cristalline, la valeur du couplage peut être choisie.

Les intérêts du report de couches monocristallines piézoélectriques pour des applications acoustiques sont notamment présentés dans des publications de NGK insulator et comme décrit dans l'article : Y. Osugi, T. Yoshino, K. Suzuki, T. Hirai, Microwave Symp., 873 (2007) ainsi que dans les articles de M. Pijolat, J.S. Moulet, A. Reinhardt, E. Defaÿ, C. Deguet, D. Gachon, B. Ghyselen, M. Aïd, S. Ballandras, IEEE Ultras. Symp., 201 (2008), ou dans les articles suivants de J.S. Moulet, M. Pijolat, J. Dechamp, F. Mazen, A. Tauzin, F. Rieutord, A. Reinhardt, E. Defaÿ, C. Deguet, B. Ghyselen, L. Clavelier, M. Aïd, S. Ballandras, C. Mazuré, IEEE IEDM, (2008) ou bien encore de M. Pijolat, D. Mercier, A. Reinhardt, E. Defay, C. Deguet, M. Aid, J.S. Moulet, B. Ghyselen, S. Ballandras, IEEE Freq. Contr. Symp., 290 (2009).

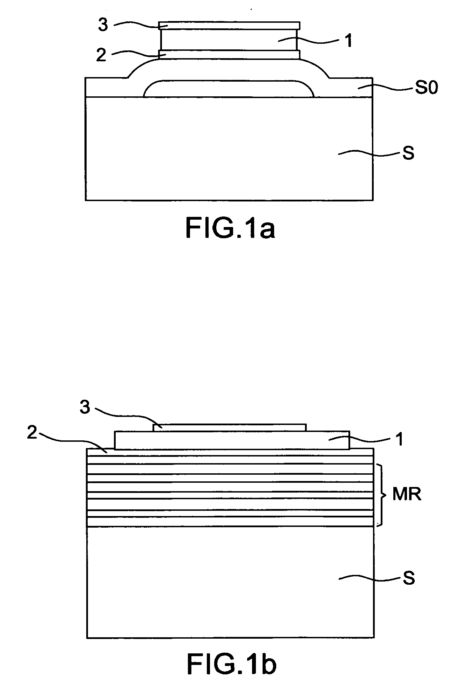

Deux types de technologies ont été décrites dans des brevets, permettant d'obtenir des résonateurs découplés de l'effet du substrat, soit pour élaborer des dispositifs à ondes de volume dans des films suspendus encore dénommés « Film Bulk Acoustic Resonator » ou « FBAR » ainsi que « Solidly Mounted Resonator » ou « SMR », présentant des structures telles que celles illustrées respectivement en figures 1a et 1b. Les premiers comportent des couches minces suspendues de matériau piézoélectrique 1 inséré entre deux électrodes 2 et 3 à la surface d'un substrat S dans lequel on a réalisé une structure suspendue S₀, les seconds peuvent comporter par exemple des miroirs de Bragg MR permettant de confiner les ondes de volume et ainsi les découpler de l'effet du substrat S.

La première technologie décrite dans les brevets US20070200458 et US20070210878A1, consiste en un collage puis amincissement d'un substrat de LiNbO₃ jusqu'au micron, les dispositifs actifs reposants sur des gaps d'air. Un tel amincissement en dessous du micron tout en conservant une grande homogénéité en épaisseur lors de l'amincissement est très difficile.

La deuxième technologie décrite dans le brevet US6767749 présente divers procédés pour obtenir une couche mince monocristalline acoustiquement découplée du substrat. Cette technique est basée sur l'implantation d'ions gazeux (typiquement hydrogène) dite technique d'implantation/fracture, le procédé par implantation/fracture permettant quant à lui d'atteindre de très faibles épaisseurs typiquement pouvant être inférieures à environ 0,5 µm mais étant limité pour les valeurs supérieures à 2µm avec un implanteur classique de la microélectronique et à quelques dizaines de µm avec des implanteurs haute énergie. Le procédé de report par implantation/fracture est décrit en détails dans l'article : "Silicon on insulator material technology", Electronic letters, 31 (14), p1201-1202 (1995), il permet notamment la réalisation de substrats SOI « Silicon On Insulator » correspondant à du silicium sur isolant. Il est dans ce brevet utilisé pour reporter ladite couche sur un empilement type réflecteur de Bragg ou encore sur des cavités.

C'est cette dernière solution qui est jugée très difficile en raison des technologies à employer pour le report. Un matériau raidisseur est nécessaire pour assurer le report au-dessus des cavités et peut être enlevé par la suite. Pendant l'étape de collage, le vide doit être fait dans les cavités pour éviter des problèmes de surpression lors de montée en température ultérieure, étape délicate nécessitant des machines de collage spéciales.

Le problème inhérent à ces deux technologies demeure la difficulté d'obtenir la couche mince suspendue.

Le procédé de la présente invention a pour but de surmonter cette difficulté en utilisant une couche dite sacrificielle qui délimite, une fois retirée après l'obtention du film mince, la cavité nécessaire pour avoir un dispositif à ondes de volume de type FBAR.

Plus précisément, la présente invention a pour objet un procédé de fabrication d'un résonateur acoustique à ondes de volume (FBAR) comprenant au moins localement une couche mince de matériau piézoélectrique partiellement suspendue, caractérisé en ce qu'il comporte les étapes suivantes :
- la formation d'au moins une première électrode dite inférieure à la surface d'une couche mince de matériau piézoélectrique ;
- le dépôt d'une couche dite sacrificielle à la surface de ladite couche mince de matériau piézoélectrique et de ladite première électrode définissant un premier ensemble ;
- l'assemblage dudit premier ensemble avec un second substrat ;
- la formation d'au moins une seconde électrode dite électrode supérieure sur la face de ladite couche mince de matériau piézoélectrique opposée à la face comportant ladite première électrode ;
- l'élimination de la couche sacrificielle de manière à dégager ladite couche mince de matériau piézoélectrique et ladite première électrode et définir le résonateur à ondes de volume.

Selon une variante de l'invention, le procédé comporte l'élaboration d'un motif de couche sacrificielle enrobant ladite première électrode.

Selon une variante de l'invention, le procédé comprend en outre une opération de gravure locale de la couche mince de matériau piézoélectrique pour permettre l'élimination de la couche sacrificielle.

Selon une variante de l'invention, le procédé comprend en outre le dépôt d'une couche de planarisation sur la couche sacrificielle enrobant ladite première électrode, préalablement à l'assemblage du premier ensemble avec le second substrat.

Selon une variante de l'invention, le second substrat comporte en surface une couche pouvant avantageusement être de même nature que celle de la couche de planarisation à la surface de la couche sacrificielle.

Selon une variante de l'invention, le procédé comporte en outre le dépôt d'une couche de protection préalable au dépôt de la couche de planarisation, cette couche de protection pouvant avantageusement assurer la fonction de couche d'arrêt de gravure.

Selon une variante de l'invention, le procédé comporte en outre une étape de planarisation de la couche de planarisation, préalable à l'opération d'assemblage.

Ainsi en effectuant le dépôt d'une couche englobant la couche sacrificielle et les électrodes, qui peut avantageusement être planarisée, on peut procéder à un assemblage plan-plan de très bonne qualité.

Selon une variante de l'invention, le procédé comporte la fabrication de ladite couche mince de matériau piézoélectrique par les étapes suivantes :
- la définition d'une couche mince de matériau piézoélectrique au sein d'un premier substrat de matériau piézoélectrique comportant ladite première électrode et la couche sacrificielle et définissant un ensemble précurseur ;
- l'assemblage dudit ensemble précurseur côté première électrode, sur le second substrat ;
- la séparation dudit premier substrat de matériau piézoélectrique de ladite couche mince de matériau piézoélectrique.

Selon une variante de l'invention, la définition de la couche mince de premier matériau piézoélectrique comporte l'implantation d'ions dans ledit premier substrat pour créer dans le matériau piézoélectrique une zone fragile enterrée définissant la couche mince de matériau piézoélectrique.

Selon une variante de l'invention, la séparation est réalisée par traitement thermique.

Selon une variante de l'invention, le procédé comprend :
- une étape d'assemblage d'un premier substrat tout ou en partie en matériau piézoélectrique, ledit matériau piézoélectrique étant recouvert de ladite première électrode et de la couche sacrificielle avec la surface d'un second substrat ;
- une étape d'amincissement du premier substrat par rodage et/ou polissage de manière à définir une couche mince de matériau piézoélectrique.

Selon une variante de l'invention, l'assemblage est effectué par collage moléculaire.

Selon une variante de l'invention, le matériau piézoélectrique est de type niobate de lithium, tantalate de lithium ou quartz.

Selon une variante de l'invention, la gravure de la couche de matériau piézoélectrique est effectuée par photolithographie et gravure de la couche.

Selon une variante de l'invention, la couche sacrificielle comprend un matériau de type polymère ou oxyde de silicium ou métal pouvant être du titane, du tungstène ou du molybdène.

Selon une variante de l'invention, l'élimination du motif de couche sacrificielle est effectuée par attaque en solution acide pouvant être de type acide fluorhydrique ou acide phosphorique ou fluorure de Xénon.

Selon une variante de l'invention, la couche de planarisation est de type nitrure de silicium, oxyde de silicium ou un métal de type tungstène ou aluminium.

La couche sacrificielle et la première couche de planarisation peuvent ainsi être constituées par exemple par le même matériau. L'attaque des couches peut être sélective ou non, dans ce dernier cas, le temps de gravure est le paramètre déterminant, l'attaque sélective demeurant une variante préférentielle.

Selon une variante de l'invention, la couche intermédiaire est de type nitrure de titane ou nitrure d'aluminium.

Selon une variante de l'invention, le second substrat est en matériau de type niobate de lithium, tantalate de lithium ou quartz ou silicium.

Selon une variante de l'invention, la première et/ou la seconde électrode sont faites d'un métal tel que le platine, l'aluminium ou le molybdène ou le cuivre ou le tungstène ou le chrome ou un alliage de cuivre et d'aluminium ou un alliage d'aluminium et de silicium ou le Ruthénium.

L'invention a aussi pour objet un procédé collectif de fabrication de résonateurs à ondes de volume (FBAR), chaque dispositif comprenant au moins localement une couche mince de matériau piézoélectrique partiellement suspendue, caractérisé en ce qu'il comporte les étapes suivantes :
- la formation d'un ensemble de premières électrodes dites inférieures à la surface d'une couche mince de matériau piézoélectrique ;
- le dépôt d'une couche sacrificielle à la surface de ladite couche mince de matériau piézoélectrique et desdites premières électrodes définissant un premier ensemble ;
- l'assemblage dudit premier ensemble avec un second substrat ;
- la formation d'un ensemble de secondes électrodes dites électrodes supérieures sur la face de ladite couche mince de matériau piézoélectrique opposée à la face comportant lesdites premières électrodes ;
- l'élimination de la couche sacrificielle de manière à dégager ladite couche mince de matériau piézoélectrique et lesdites premières électrodes et définir les résonateurs à ondes de volume.

Selon une variante de l'invention, le procédé collectif comprend l'élaboration de motifs de couche sacrificielle enrobant lesdites premières électrodes.

Selon une variante de l'invention, les électrodes inférieures et supérieures sont définies de manière à pouvoir réaliser une fonction de filtrage type réseau.

Selon une variante de l'invention, les électrodes inférieures et supérieures sont définies de manière à pouvoir réaliser une fonction de filtrage type échelle.

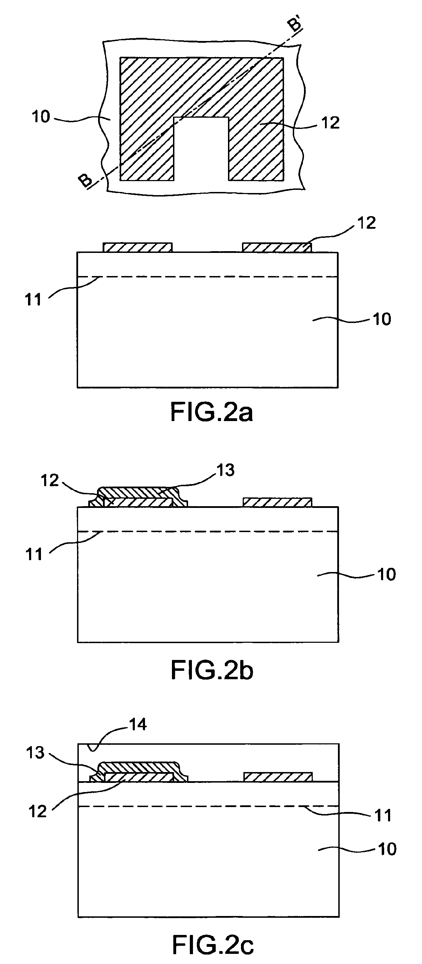

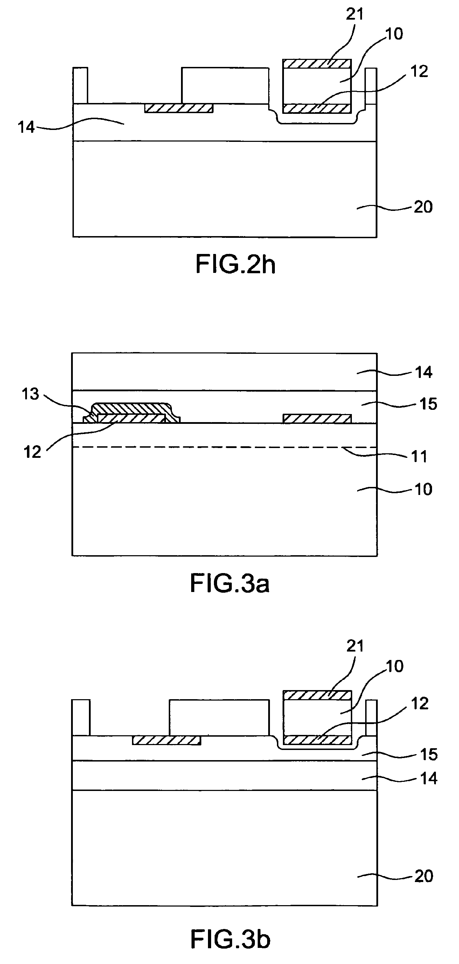

L'invention sera mieux comprise et d'autres avantages apparaîtront à la lecture de la description qui va suivre donnée à titre non limitatif et grâce aux figures annexées parmi lesquelles :
■ les figures 1a et 1b illustrent deux types de dispositifs à ondes de volume selon l'art connu ;
■ les figures 2a à 2h illustrent les différentes étapes d'un exemple de procédé selon l'invention ;
■ les figures 3a et 3b illustrent deux étapes spécifiques d'un exemple de procédé de l'invention.

Selon une première variante de l'invention, le procédé comporte les étapes suivantes permettant de réaliser un dispositif de type FBAR, illustré par l'ensemble des figures 2a à 2h.

Dans une première étape illustrée en figure 2a, on réalise dans un substrat 10, une implantation ionique à une certaine profondeur avec des atomes afin de créer une zone fragilisée 11 à une épaisseur déterminée et très homogène.

On procède alors au dépôt d'une couche de métal et à des opérations de photolithographie permettant de définir une électrode appelée électrode inférieure 12. La figure 2a met en évidence par une vue de dessus la définition de ladite électrode inférieure ainsi que par une vue en coupe BB'.

Dans une seconde étape illustrée en figure 2b, on procède au dépôt d'une couche sacrificielle 13, à la surface du substrat 10 recouvert de l'électrode 12. Par des étapes de photolithogarphie on définit un motif dans la couche sacrificielle englobant l'électrode dit inférieure définie dans la couche 12.

Dans une troisième étape on procède au dépôt d'une couche de planarisation 14, comme illustré en figure 2c. Cette couche peut être avantageusement travaillée par polissage par un procédé par exemple de type chimico-mécanique « CMP » comme il sera décrit plus en détails dans un exemple de fabrication, de manière à assurer une surface bien plane et permettre un report plan-plan avec le second substrat.

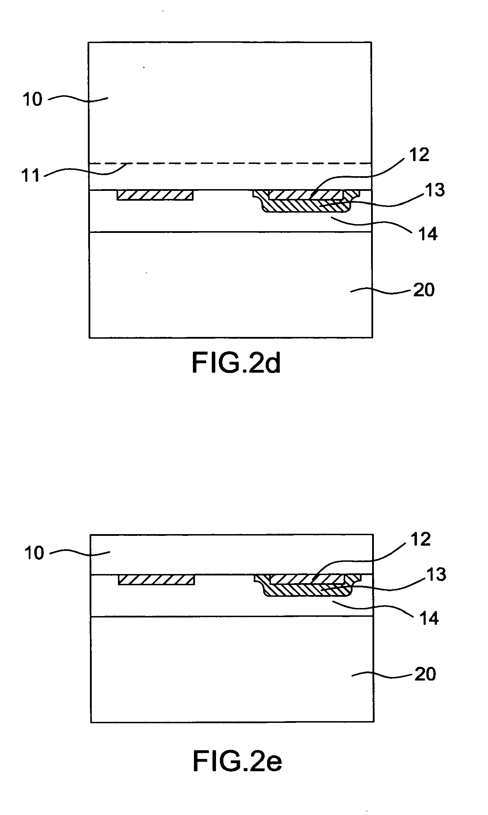

Dans une quatrième étape on procède au report de l'empilement préalablement constitué sur un second substrat 20, mis en contact via la couche de planarisation, comme illustré en figure 2d. Avantageusement, ce report est effectué par une opération de collage moléculaire.

Dans une cinquième étape on procède à l'amincissement du substrat en matériau piézoélectrique par traitement thermique à température typiquement comprise entre environ 100°C et 500°C afin d'initier le transfert de la couche fine de matériau piézoélectrique 10, permettant de séparer la couche mince à transférer du reste du substrat de matériau piézoélectrique. On obtient l'empilement représenté en figure 2e avec la couche fine de matériau piézoélectrique reportée via la couche de planarisation et le motif de couche sacrificielle au dessus du second substrat 20.

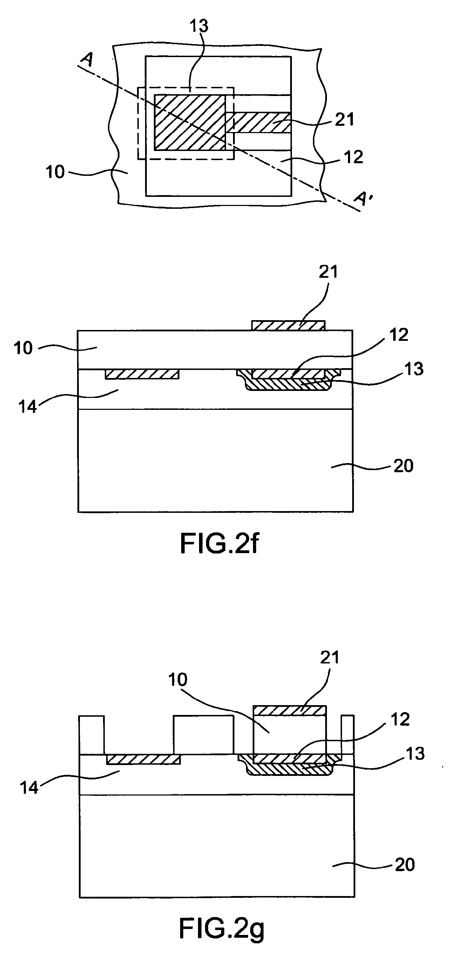

Dans une sixième étape, on réalise l'électrode supérieure 21 à partir du dépôt d'une couche de métallisation et d'opérations de photolithographie, comme représenté en figure 2f (vue de dessus et vue en coupe AA').

Dans une septième étape, on effectue une opération de gravure partielle de la couche fine de matériau piézoélectrique permettant de définir les flancs du dispositif à ondes de volume recherché, comme représenté en figure 2g.

Dans une huitième étape illustrée en figure 2h, on procède alors à l'attaque du motif de la couche sacrificielle permettant de définir le film mince suspendu de matériau piézoélectrique inséré entre deux électrodes et constitutif du dispositif « FBAR ».

Selon une seconde variante, le procédé de la présente invention prévoit en outre le dépôt d'une couche intermédiaire 15, déposée à la surface de la couche sacrificielle 13, comme illustré sur la figure 3a qui intègre l'ensemble des premières étapes identiques à celles décrites dans les étapes de la première variante illustrée par les figures 2a et 2b.

Les étapes suivantes de cette variante de procédé sont identiques à celles de la première variante.

Lors de l'attaque de la couche sacrificielle cette couche intermédiaire est destinée à ne pas être attaquée intégralement.

La figure 3b illustre cette opération d'attaque de la couche sacrificielle 13, laissant au moins partiellement la couche intermédiaire 15.

Il est à noter que le second substrat 20 peut être monolithique ou multicouches et en particulier, il peut comporter sur sa face mise en contact avec le premier ensemble, une couche de même type que la couche de planarisation, pour favoriser l'adhésion moléculaire de cet assemblage ou encore une couche de collage.

### Exemple de réalisation

Un premier substrat d'un matériau piézoélectrique monocristallin 10 tel que le niobate de lithium, le tantalate de lithium ou le quartz est implanté à une certaine profondeur avec des ions 11 tels que l'Hydrogène ou l'Hélium afin de créer une zone fragilisée à une épaisseur déterminée et extrêmement homogène. Cette épaisseur peut varier d'un micron à quelques dizaines de nanomètres déterminant l'épaisseur de la couche mince destinée à être reportée ainsi que la fréquence du résonateur.

Sur ce premier substrat sont ensuite effectuées les opérations suivantes :
une première opération de photolithographie d'un métal 12 tel que le platine, le tungstène, le molybdène ou l'aluminium destiné à former l'électrode inférieure dont l'épaisseur peut varier entre quelques dizaines de nanomètres et quelques centaines de nanomètres ;
une seconde opération de photolithographie d'une couche sacrificielle 13 telle qu'un polymère ou de l'oxyde de Silicium destinée à constituer le gap d'air par la suite. Cette couche sacrificielle possède une épaisseur d'une dizaine de nanomètres à plusieurs microns.

On procède ensuite au dépôt d'une couche de planarisation en matériau tel que le nitrure de silicium, l'oxyde de silicium ou un métal tel que le tungstène ou de l'aluminium permettant alors de recouvrir entièrement les couches précédentes.

Un procédé type polissage mécanico-chimique CMP est alors effectué sur ce premier substrat afin d'obtenir une couche d'oxyde plane, dont la rugosité ne dépasse pas 5 Angstrôms RMS et est ainsi prête pour le report sur un second substrat 20 d'un matériau tel que le niobate de lithium, le tantalate de lithium ou le quartz. De manière générale, le procédé CMP pour "chemical mechanical planarization" ou "chemical mechanical polishing" (planarisation ou polissage mécano chimique), est un processus qui aplanit les reliefs sur les couches d'oxydes de silicium, de poly-silicium ainsi que les couches métalliques. Il est utilisé pour planariser ces couches afin de les préparer aux étapes lithographiques suivantes, évitant ainsi les problèmes de mise au point liés aux variations de profondeur lors de l'illumination de la résine photosensibles. Il s'agit d'une méthode très performante pour la fabrication de circuits électroniques à très haute densité d'intégration. Le CMP est un processus de lissage et de planarisation des surfaces combinant des actions chimiques et mécaniques, un mélange de gravure chimique et de polissage mécanique à abrasif libre. Le rodage mécanique seul cause trop de dégâts sur les surfaces et la gravure humide seule ne permet pas d'obtenir une bonne planarisation. Les réactions chimiques étant isotropiques, elles attaquent les matériaux indifféremment dans toutes les directions. Le procédé CMP présente l'intérêt de combiner les deux effets en même temps.

Le report du substrat 10 et des couches précédemment réalisées est effectué sur un second substrat hôte 20.

On procède à une élévation de la température de l'ensemble de manière à créer une onde de fracture dans le plan de la zone implantée aboutissant à la séparation de la couche fine de matériau piézoélectrique et de son substrat.

Une opération de photolithographie de l'électrode supérieure 21 faite d'un métal tel que le platine, l'aluminium ou le molybdène est alors réalisée suivie d'une photolithographie d'ouvertures dans le matériau piézoélectrique. Ces ouvertures permettent l'accès d'une part à l'électrode inférieure pour les tests électriques et d'autre part à la couche sacrificielle qui est ainsi gravée par exemple en solution humide au moyen d'acide fluorhydrique ou d'acide phosphorique ou au moyen d'une phase vapeur telle que le fluorure de Xénon ou l'acide fluorhydrique vapeur.

Il est à noter que dans la réalisation d'un exemple de procédé de l'invention selon la seconde variante décrite, la couche intermédiaire peut notamment être en matériau de type nitrure de titane ou nitrure d'aluminium et avoir une épaisseur comprise entre environ un nanomètre et une centaine de nanomètres.

En résumé, l'intérêt de la présente invention réside dans la combinaison des principales caractéristiques suivantes :
- l'utilisation d'une couche sacrificielle pour réaliser le découplage du substrat nécessaire pour un résonateur de type « FBAR » ;
- l'emploi d'une technique CMP sur l'oxyde permettant une surface plane pour l'opération d'obtention de couche fine de matériau piézoélectrique par implantation ionique, opération parfaitement maîtrisée ;
- la gravure de la couche piézoélectrique débouchant à la fois sur la couche sacrificielle et sur l'électrode supérieure.

Grâce au procédé de la présente invention, il est particulièrement intéressant de réaliser de manière collective un ensemble de résonateurs de type « FBAR » et ainsi pouvoir réaliser une fonction de filtrage type réseau ou échelle dont la bande passante est largement supérieure à ce qui peut être réalisé aujourd'hui en filtre acoustique RF.

## Revendications

1. Procédé de fabrication d'un résonateur acoustique à ondes de volume (FBAR) comprenant au moins localement une couche mince de matériau piézoélectrique (10) partiellement suspendue, **caractérisé en ce qu'**il comporte les étapes suivantes :
- la formation d'au moins une première électrode dite inférieure (12) à la surface d'une couche mince de matériau piézoélectrique ;
- le dépôt d'une couche dite sacrificielle (13) à la surface de ladite couche mince de matériau piézoélectrique et de ladite première électrode, définissant un premier ensemble ;
- l'assemblage dudit premier ensemble avec un second substrat ;
- la formation d'au moins une seconde électrode dite électrode supérieure (21) sur la face de ladite couche mince de matériau piézoélectrique opposée à la face comportant ladite première électrode (20) ;
- l'élimination de la couche sacrificielle de manière à dégager ladite couche mince de matériau piézoélectrique et ladite première électrode et définir le résonateur à ondes de volume.

2. Procédé de fabrication d'un résonateur selon la revendication 1, **caractérisé en ce qu'**il comprend l'élaboration d'un motif de couche sacrificielle enrobant ladite première électrode de manière à constituer le premier ensemble.

3. Procédé de fabrication d'un résonateur selon l'une des revendications 1 ou 2, **caractérisé en ce qu'**il comprend en outre une opération de gravure locale de la couche mince de matériau piézoélectrique pour permettre l'élimination de la couche sacrificielle.

4. Procédé de fabrication d'un résonateur selon l'une des revendications 1 à 3, **caractérisé en ce qu'**il comprend en outre le dépôt d'une couche de planarisation (14) sur la couche sacrificielle enrobant ladite première électrode, préalablement à l'assemblage du premier ensemble avec le second substrat.

5. Procédé de fabrication d'un résonateur selon l'une des revendications 1 à 4, **caractérisé en ce que** le second substrat comporte en surface une couche pouvant être de même nature que celle de la couche de planarisation à la surface de la couche sacrificielle.

6. Procédé de fabrication d'un résonateur selon l'une des revendications 4 ou 5, **caractérisé en ce qu'**il comporte en outre le dépôt d'une couche de protection (15) préalable au dépôt de la couche de planarisation.

7. Procédé de fabrication d'un résonateur selon l'une des revendications 4 à 6, **caractérisé en ce qu'**il comporte en outre une étape de planarisation de la couche de planarisation, préalable à l'opération d'assemblage.

8. Procédé de fabrication d'un résonateur selon l'une des revendications 1 à 7, **caractérisé en ce qu'**il comporte la fabrication de ladite couche mince de matériau piézoélectrique par les étapes suivantes :
- la définition d'une couche mince de matériau piézoélectrique au sein d'un premier substrat de matériau piézoélectrique comportant ladite première électrode et la couche sacrificielle et définissant un ensemble précurseur ;
- l'assemblage dudit ensemble précurseur côté première électrode, sur le second substrat ;
- la séparation dudit premier substrat de matériau piézoélectrique de ladite couche mince de matériau piézoélectrique.

9. Procédé de fabrication d'un résonateur selon la revendication 8, **caractérisé en ce que** la définition de la couche mince de premier matériau piézoélectrique comporte l'implantation d'ions dans ledit premier substrat pour créer dans le matériau piézoélectrique une zone fragile enterrée définissant la couche mince de matériau piézoélectrique.

10. Procédé de fabrication d'un résonateur selon l'une des revendications 8 ou 9, **caractérisé en ce que** la séparation est réalisée par traitement thermique.

11. Procédé de fabrication d'un résonateur selon l'une des revendications 1 à 7, **caractérisé en ce qu'**il comprend :
- une étape d'assemblage d'un premier substrat tout ou en partie en matériau piézoélectrique, ledit matériau piézoélectrique étant recouvert de ladite première électrode et de la couche sacrificielle avec la surface d'un second substrat ;
- une étape d'amincissement du premier substrat par rodage et/ou polissage de manière à définir une couche mince de matériau piézoélectrique.

12. Procédé de fabrication d'un résonateur selon l'une des revendications 1 à 11, **caractérisé en ce que** l'assemblage est effectué par collage moléculaire.

13. Procédé de fabrication d'un résonateur selon l'une des revendications 1 à 12, **caractérisé en ce que** le matériau piézoélectrique est de type niobate de lithium, tantalate de lithium ou quartz.

14. Procédé de fabrication d'un résonateur selon la revendication 13, **caractérisé en ce que** la gravure de la couche de matériau piézoélectrique est effectuée par photolithographie et gravure de la couche.

15. Procédé de fabrication d'un résonateur selon l'une des revendications 1 à 14, **caractérisé en ce que** la couche sacrificielle comprend un matériau de type polymère ou oxyde de silicium ou métal pouvant être du titane, du tungstène ou du molybdène.

16. Procédé de fabrication d'un résonateur selon la revendication 15, **caractérisé en ce que** l'élimination de la couche sacrificielle est effectuée par attaque en solution acide pouvant être de type acide fluorhydrique ou acide phosphorique, ou fluorure de Xénon.

17. Procédé de fabrication d'un résonateur selon l'une des revendications 1 à 16, **caractérisé en ce que** la couche de planarisation est de type nitrure de silicium, oxyde de silicium ou un métal de type tungstène ou aluminium.

18. Procédé de fabrication d'un résonateur selon l'une des revendications 1 à 17, **caractérisé en ce que** la couche intermédiaire (15) est de type nitrure de titane ou nitrure d'aluminium.

19. Procédé de fabrication d'un résonateur selon l'une des revendications 1 à 18, **caractérisé en ce que** le second substrat est en matériau de type niobate de lithium, tantalate de lithium ou quartz.

20. Procédé de fabrication d'un résonateur selon l'une des revendications 1 à 19, **caractérisé en ce que** la première et/ou la seconde électrode sont faites d'un métal tel que le platine, l'aluminium ou le molybdène, ou le cuivre ou le tungstène ou le chrome ou un alliage de cuivre et d'aluminium ou un alliage de silicium et d'aluminium ou le Ruthénium.

21. Procédé collectif de fabrication de résonateurs acoustiques à ondes de volume (FBAR), chaque résonateur comprenant au moins localement une couche mince de matériau piézoélectrique (10) partiellement suspendue, **caractérisé en ce qu'**il comporte les étapes suivantes :
- la formation d'un ensemble de premières électrodes dites inférieures (12) à la surface d'une couche mince de matériau piézoélectrique ;
- le dépôt d'une couche sacrificielle (13) à la surface de ladite couche mince de matériau piézoélectrique et desdites premières électrodes définissant un premier ensemble;
- l'assemblage dudit premier ensemble avec un second substrat ;
- la formation d'un ensemble de secondes électrodes dites électrodes supérieures (21) sur la face de ladite couche mince de matériau piézoélectrique opposée à la face comportant lesdites premières électrodes ;
- l'élimination de la couche sacrificielle de manière à dégager ladite couche mince de matériau piézoélectrique et lesdites premières électrodes et définir les résonateurs à ondes de volume.

22. Procédé collectif de fabrication de résonateurs acoustiques à ondes de volume (FBAR) selon la revendication 20, **caractérisé en ce que** les électrodes inférieures et supérieures sont définies de manière à pouvoir réaliser une fonction de filtrage type réseau.

23. Procédé collectif de fabrication de résonateurs acoustiques à ondes de volume (FBAR), selon la revendication 20, **caractérisé en ce que** les électrodes inférieures et supérieures sont définies de manière à pouvoir réaliser une fonction de filtrage type échelle.

## Claims

1. A method for manufacturing a bulk wave acoustic resonator (FBAR) comprising at least locally a partially suspended thin layer of piezoelectric material (10), **characterised in that** it comprises the following steps:
- forming at least one first electrode, referred to as the lower electrode (12), on the surface of a thin layer of piezoelectric material;
- depositing a layer, referred to as the sacrificial layer (13), on the surface of said thin layer of piezoelectric material and of said first electrode, defining a first assembly;
- assembling said first assembly with a second substrate;
- forming at least one second electrode, referred to as the upper electrode (21), on the face of said thin layer of piezoelectric material opposite the face that comprises said first electrode (20);
- removing the sacrificial layer so as to separate said thin layer of piezoelectric material and said first electrode and define the bulk wave resonator.

2. The method for manufacturing a resonator according to claim 1, **characterised in that** it comprises developing a pattern of the sacrificial layer encapsulating said first electrode so as to constitute the first assembly.

3. The method for manufacturing a resonator according to claim 1 or 2, **characterised in that** it further comprises an operation for locally etching the thin layer of piezoelectric material to allow the removal of the sacrificial layer.

4. The method for manufacturing a resonator according to any one of claims 1 to 3, **characterised in that** it further comprises depositing a planarisation layer (14) onto the sacrificial layer encapsulating said first electrode before assembling the first assembly with the second substrate.

5. The method for manufacturing a resonator according to one of claims 1 to 4, **characterised in that** the second substrate comprises a layer on its surface that can be of the same type as that of the planarisation layer on the surface of the sacrificial layer.

6. The method for manufacturing a resonator according to any one of claims 4 to 5, **characterised in that** it further comprises depositing a protection layer (15) before depositing the planarisation layer.

7. The method for manufacturing a resonator according to any one of claims 4 to 6, **characterised in that** it further comprises a step of planarising the planarisation layer before the assembly operation.

8. The method for manufacturing a resonator according to any one of claims 1 to 7, **characterised in that** it comprises manufacturing said thin layer of piezoelectric material by the following steps:
- defining a thin layer of piezoelectric material within a first substrate of piezoelectric material which comprises said first electrode and said sacrificial layer and defining a precursor assembly;
- assembling said precursor assembly on the first electrode side with the second substrate;
- separating said first substrate of piezoelectric material from said thin layer of piezoelectric material.

9. The method for manufacturing a resonator according to claim 8, **characterised in that** defining the thin layer of first piezoelectric material includes arranging ions in said first substrate to create a fragile buried zone in the piezoelectric material that defines the thin layer of piezoelectric material.

10. The method for manufacturing a resonator according to claim 8 or 9, **characterised in that** the separation is undertaken by heat treatment.

11. The method for manufacturing a resonator according to any one of claims 1 to 7, **characterised in that** it comprises:
- a step of assembling a first substrate wholly or partly made from piezoelectric material, said piezoelectric material being covered with said first electrode and the sacrificial layer, with the surface of a second substrate;
- a step of thinning the first substrate by lapping and/or polishing so as to define a thin layer of piezoelectric material.

12. The method for manufacturing a resonator according to any one of claims 1 to 11, **characterised in that** the assembly is undertaken by molecular bonding.

13. The method for manufacturing a resonator according to any one of claims 1 to 12, **characterised in that** the piezoelectric material is of the lithium niobate, lithium tantalite or quartz type.

14. The method for manufacturing a resonator according to claim 13, **characterised in that** etching the layer of piezoelectric material is undertaken by photolithography and etching of the layer.

15. The method for manufacturing a resonator according to one of claims 1 to 14, **characterised in that** the sacrificial layer comprises a material of the polymer or silicon oxide type or metal that can be of the titanium, tungsten or molybdenum type.

16. The method for manufacturing a resonator according to claim 15, **characterised in that** the sacrificial layer is removed by an attack from an acid solution that can be of the hydrofluoric acid or phosphoric acid or Xenon fluoride type.

17. The method for manufacturing a resonator according to any one of claims 1 to 16, **characterised in that** the planarisation layer is of the silicon nitride or silicon oxide type or a metal of the tungsten or aluminium type.

18. The method for manufacturing a resonator according to any one of claims 1 to 17, **characterised in that** the intermediate layer (15) is of the titanium nitride or aluminium nitride type.

19. The method for manufacturing a resonator according to one of claims 1 to 18, **characterised in that** the second substrate is a material of the lithium niobate, lithium tantalite or quartz type.

20. The method for manufacturing a resonator according to any one of claims 1 to 19, **characterised in that** the first and/or second electrode are made from a metal such as platinum, aluminium or molybdene or copper or tungsten or chrome or a copper and aluminium alloy or a silicon and aluminium alloy or ruthenium.

21. A collective method for manufacturing bulk wave acoustic resonators (FBAR), each resonator comprising at least locally a partially suspended thin layer of piezoelectric material (10), **characterised in that** it comprises the following steps:
- forming an assembly of first electrodes, referred to as lower electrodes (12), on the surface of a thin layer of piezoelectric material;
- depositing a sacrificial layer (13) on the surface of said thin layer of piezoelectric material and of said first electrodes that define a first assembly;
- assembling said first assembly with a second substrate;
- forming an assembly of second electrodes, referred to as upper electrodes (21), on the face of said thin layer of piezoelectric material opposite the face that comprises said first electrodes;
- removing the sacrificial layer so as to expose said thin layer of piezoelectric material and said first electrodes and define the bulk wave resonators.

22. The collective method for manufacturing bulk wave acoustic resonators (FBAR) according to claim 20, **characterised in that** the lower and upper electrodes are defined so as to be able to perform a network type filtering function.

23. The collective method for manufacturing bulk wave acoustic resonators (FBAR) according to claim 20, **characterised in that** the lower and upper electrodes are defined so as to be able to perform a ladder type filtering function.

## Patentansprüche

1. Verfahren zur Herstellung eines mit Volumenwellen arbeitenden akustischen Resonators (FBAR), der wenigstens lokal eine dünne teilweise suspendierte Schicht aus piezoelektrischem Material (10) umfasst, **dadurch gekennzeichnet, dass** es die folgenden Schritte beinhaltet:
- Bilden von wenigstens einer ersten Elektrode, untere Elektrode (12) genannt, auf der Oberfläche einer dünnen Schicht aus piezoelektrischem Material;
- Absetzen einer Schicht, Opferschicht (13) genannt, auf die Oberfläche der dünnen Schicht aus piezoelektrischem Material und der ersten Elektrode, um eine erste Baugruppe zu definieren;
- Zusammenfügen der ersten Baugruppe mit einem zweiten Substrat;
- Bilden von wenigstens einer zweiten Elektrode, obere Elektrode (21) genannt, auf der Fläche der dünnen Schicht aus piezoelektrischem Material gegenüber der Fläche, die die erste Elektrode (20) umfasst;
- Entfernen der Opferschicht zum Ablösen der dünnen Schicht aus piezoelektrischem Material und der ersten Elektrode und Definieren des mit Volumenwellen arbeitenden Resonators.

2. Verfahren zur Herstellung eines Resonators nach Anspruch 1, **dadurch gekennzeichnet, dass** es das Ausarbeiten eines Opferschichtmotivs beinhaltet, das die erste Elektrode so umhüllt, dass die erste Baugruppe entsteht.

3. Verfahren zur Herstellung eines Resonators nach Anspruch 1 oder 2, **dadurch gekennzeichnet, dass** es darüber hinaus einen Vorgang des lokalen Ätzens der dünnen Schicht aus piezoelektrischem Material beinhaltet, damit die Opferschicht entfernt werden kann.

4. Verfahren zur Herstellung eines Resonators nach einem der Ansprüche 1 bis 3, **dadurch gekennzeichnet, dass** es darüber hinaus das Absetzen einer Planarisierungsschicht (14) auf die die erste Elektrode umhüllende Opferschicht vor dem Zusammenfügen der ersten Baugruppe mit dem zweiten Substrat beinhaltet.

5. Verfahren zur Herstellung eines Resonators nach einem der Ansprüche 1 bis 4, **dadurch gekennzeichnet, dass** das zweite Substrat an der Oberfläche eine Schicht aufweist, die von derselben Art sein kann wie die Planarisierungsschicht auf der Oberfläche der Opferschicht.

6. Verfahren zur Herstellung eines Resonators nach Anspruch 4 oder 5, **dadurch gekennzeichnet, dass** es darüber hinaus das Absetzen einer Schutzschicht (15) vor dem Absetzen der Planarisierungsschicht beinhaltet.

7. Verfahren zur Herstellung eines Resonators nach einem der Ansprüche 4 bis 6, **dadurch gekennzeichnet, dass** es darüber hinaus einen Schritt des Planarisierens der Planarisierungsschicht vor dem Zusammenfügungsvorgang beinhaltet.

8. Verfahren zur Herstellung eines Resonators nach einem der Ansprüche 1 bis 7, **dadurch gekennzeichnet, dass** es das Herstellen der dünnen Schicht aus piezoelektrischem Material mit den folgenden Schritten beinhaltet:
- Definieren einer dünnen Schicht aus piezoelektrischem Material im Innern eines ersten Substrats aus piezoelektrischem Material, das die erste Elektrode und die Opferschicht umfasst und eine Vorläuferbaugruppe definiert;
- Zusammenfügen der Vorläuferbaugruppe auf der Seite der ersten Elektrode mit dem zweiten Substrat;
- Trennen des ersten Substrats aus piezoelektrischem Material von der dünnen Schicht aus piezoelektrischem Material.

9. Verfahren zur Herstellung eines Resonators nach Anspruch 8, **dadurch gekennzeichnet, dass** das Definieren der dünnen Schicht aus erstem piezoelektrischem Material das Implantieren von Ionen in das erste Substrat beinhaltet, um in dem piezoelektrischen Material eine vergrabene zerbrechliche Zone zu erzeugen, die die dünne Schicht aus piezoelektrischem Material definiert.

10. Verfahren zur Herstellung eines Resonators nach Anspruch 8 oder 9, **dadurch gekennzeichnet, dass** die Trennung durch Wärmebehandlung erzielt wird.

11. Verfahren zur Herstellung eines Resonators nach einem der Ansprüche 1 bis 7, **dadurch gekennzeichnet, dass** es Folgendes beinhaltet:
- einen Schritt des Zusammenfügens eines ersten Substrats ganz oder teilweise aus piezoelektrischem Material, wobei das piezoelektrische Material von der ersten Elektrode und von der Opferschicht bedeckt wird, mit der Oberfläche eines zweiten Substrats;
- einen Schritt des Verdünnens des ersten Substrats durch Läppen und/oder Polieren, um eine dünne Schicht aus piezoelektrischem Material zu definieren.

12. Verfahren zur Herstellung eines Resonators nach einem der Ansprüche 1 bis 11, **dadurch gekennzeichnet, dass** das Zusammenfügen durch molekulares Kleben erfolgt.

13. Verfahren zur Herstellung eines Resonators nach einem der Ansprüche 1 bis 12, **dadurch gekennzeichnet, dass** das piezoelektrische Material vom Lithiumniobat-, Lithiumtantalat- oder Quarztyp ist.

14. Verfahren zur Herstellung eines Resonators nach Anspruch 13, **dadurch gekennzeichnet, dass** das Ätzen der Schicht aus piezoelektrischem Material durch Photo-Lithografie und Ätzen der Schicht erfolgt.

15. Verfahren zur Herstellung eines Resonators nach einem der Ansprüche 1 bis 14, **dadurch gekennzeichnet, dass** die Opferschicht ein Material des Polymer- oder Siliciumoxid- oder Metalltyps umfasst, wobei das Metall Titan, Wolfram oder Molybdän sein kann.

16. Verfahren zur Herstellung eines Resonators nach Anspruch 15, **dadurch gekennzeichnet, dass** das Entfernen der Opferschicht durch Behandeln mit einer sauren Lösung erfolgen kann, die vom Fluorwasserstoffsäuretyp oder vom Phosphorsäuretyp oder vom Xenonfluoridtyp sein kann.

17. Verfahren zur Herstellung eines Resonators nach einem der Ansprüche 1 bis 16, **dadurch gekennzeichnet, dass** die Planarisierungsschicht vom Siliciumnitridtyp, vom Siliciumoxidtyp oder aus einem Metall des Wolfram- oder Aluminiumtyps sein kann.

18. Verfahren zur Herstellung eines Resonators nach einem der Ansprüche 1 bis 17, **dadurch gekennzeichnet, dass** die Zwischenschicht (15) vom Titannitridtyp oder vom Aluminiumnitridtyp ist.

19. Verfahren zur Herstellung eines Resonators nach einem der Ansprüche 1 bis 18, **dadurch gekennzeichnet, dass** das zweite Substrat aus einem Material des Lithiumniobat-, Lithiumtantalat- oder Quarztyps ist.

20. Verfahren zur Herstellung eines Resonators nach einem der Ansprüche 1 bis 19, **dadurch gekennzeichnet, dass** die erste und/oder die zweite Elektrode aus einem Metall wie Platin, Aluminium oder Molybdän oder Kupfer oder Wolfram oder Chrom oder einer Legierung von Kupfer und Aluminium oder einer Legierung von Silizium und Aluminium oder Ruthenium hergestellt ist.

21. Kollektives Verfahren zur Herstellung von mit Volumenwellen arbeitenden akustischen Resonatoren (FBAR), wobei jeder Resonator wenigstens lokal eine dünne teilweise suspendierte Schicht aus piezoelektrischem Material (10) umfasst, **dadurch gekennzeichnet, dass** es die folgenden Schritte beinhaltet:
- Bilden einer Baugruppe von ersten Elektroden, untere Elektroden (12) genannt, auf der Oberfläche einer dünnen Schicht aus piezoelektrischem Material;
- Absetzen einer Opferschicht (13) auf die Oberfläche der dünnen Schicht aus piezoelektrischem Material und der ersten Elektroden, um eine erste Baugruppe zu definieren;
- Zusammenfügen der ersten Baugruppe mit einem zweiten Substrat;
- Bilden einer Baugruppe von zweiten Elektroden, obere Elektroden (21) genannt, auf der Oberfläche der dünnen Schicht aus piezoelektrischem Material gegenüber der Schicht, die die ersten Elektroden umfasst;
- Entfernen der Opferschicht, so dass die dünne Schicht aus piezoelektrischem Material und die ersten Elektroden frei gemacht werden und die mit Volumenwellen arbeitenden Resonatoren definiert werden.

22. Kollektives Verfahren zur Herstellung von mit Volumenwellen arbeitenden akustischen Resonatoren (FBAR) nach Anspruch 20, **dadurch gekennzeichnet, dass** die unteren und oberen Elektroden so definiert werden, dass eine Netzwerkfiltrierfunktion realisiert werden kann.

23. Kollektives Verfahren zur Herstellung von mit Volumenwellen arbeitenden akustischen Resonatoren (FBAR) nach Anspruch 20, **dadurch gekennzeichnet, dass** die unteren und oberen Elektroden so definiert werden, dass eine Filtrierfunktion des Leitertyps realisiert werden kann.
